# EUROPEAN PATENT SPECIFICATION

(11) **EP 2 068 608 B1**
(45) Date of publication and mention of the grant of the patent: **03.03.2010**
(21) Application number: 07291465.8
(22) Date of filing: 06.12.2007
(51) Int. Cl.: H05K 7/20

(54) **Telecommunication apparatus with air filtering**
Telekommunikationsvorrichtung mit Luftfilter
Appareil de télécommunication avec filtre à air

(43) Date of publication of application: 10.06.2009
(73) Proprietor: Alcatel Lucent, 75008 Paris (FR)
(72) Inventor: Amati, Massimo, 16138 Genova (IT); Cassinelli, Claudio, 16156 Genova (IT); Ghio, Antonio, 16037 Sestri Levante (Genova) (IT); Perasso, Aldo, 16145 Genova (IT)
(74) Representative: Schmidt, Werner Karl

(56) References cited:
- EP-A- 1 750 493
- DE-U1-202006 006 441
- US-A1- 2004 001 320

## Description

### Field of the invention

The present invention generally relates to the field of telecommunication apparatuses. In particular, the present invention relates to a telecommunication apparatus with air filtering.

### Background art

It is known that a telecommunication apparatus comprises a plurality of telecommunication devices arranged on one or more boards.

More particularly, a telecommunication apparatus typically comprises a casing with a plurality of slots, each slot being configured to house a respective board. The casing typically has an open front side, allowing insertion and extraction of the boards, and a rear side equipped with electricity supply means for supplying the boards. Further, the casing typically has fixing means allowing to fix the telecommunication apparatus to a rack. A same rack may carry several telecommunication apparatuses, e.g. vertically stacked.

The slots of the casing may be arranged so that the boards, once inserted in the slots, are either substantially horizontally stacked or substantially vertically stacked. Nowadays, telecommunication apparatuses with horizontally stacked boards are more and more widespread. Indeed, they advantageously allow to use boards with higher size than telecommunication apparatuses with vertically stacked boards, i.e. they allow to arrange a higher number of telecommunication devices on a same board, thus decreasing the overall size of the telecommunication apparatus.

A telecommunication apparatus is typically equipped with one or more fans generating an air flow flowing through the boards, with the purpose of facilitating evacuation of the power dissipated by the telecommunication devices of the boards, thus helping to keep their temperature substantially constant.

For instance, in a telecommunication apparatus with horizontally stacked boards, the casing sidewalls typically have respective openings. The fans are typically arranged inside the casing, in front of the opening of one of the sidewalls. Accordingly, when the fans are switched on, they create a substantially horizontal air flow which flows through the boards passing through the sidewall openings.

In some cases, an air filtering mechanism may be provided for filtering the air flow before it enters the casing, thus preventing possible dust from entering the telecommunication apparatus.

For instance, in a telecommunication apparatus with horizontally stacked boards, the opening of the sidewall in front of which the fans are arranged is covered by an air filter. Since the air flow must be filtered before entering the casing, according to this first solution the fans are usually pushing fans, i.e. they push the air inside the casing from outside the casing.

A telecommunication apparatus in accordance with the preamble of claim 1 is shown in US 2004/0001320.

Alternatively, in a telecommunication apparatus with horizontally stacked boards, the opening of the sidewall opposite to the sidewall in front of which the fans are arranged is covered by an air filter. Since the air flow must be filtered before entering the casing, according to this second solution the fans are usually sucking fans, i.e. they suck the air from inside the casing.

This second solution is much more efficient then the previous one in terms of evacuation of the dissipated power, and therefore it is commonly applied to telecommunication apparatuses (which are termed "class-carrier equipments") whose performance must comply with very strict requirements.

### Summary of the invention

The Applicant has noticed that, although the second solution for filtering air in a telecommunication apparatus with horizontally stacked boards is more efficient, it has some drawbacks.

Indeed, each board is typically connected to a plurality of cables (e.g. electric cables or optical cables) which link the telecommunication devices of the board either to a telecommunication device of a further telecommunication apparatus or to a line cable. Typically, such cables exit the casing through its open front side and are fixed to one of the front uprights of the rack supporting the casing. Usually, the cables are fixed to the front upright which is adjacent to the casing sidewall whose opening is covered by the air filter.

Accordingly, installing and/or removing the air filter requires to disconnect the cables from the boards, so that the sidewall can be freely accessed. However, disconnecting the cables is disadvantageous in that it requires to switch off the telecommunication apparatus. Indeed, the telecommunication apparatus should be switched off because telecom operators typically require high reliability continuous operation without loosing customer data traffic for more than few seconds per year.

Further, it is a very long and complex operation, which can be performed only by a skilled operator who has a deep knowledge of the boards since, after installation and/or removal of the air filter, the operator must be able to connect again the cables in the proper way.

Accordingly, the Applicant has faced the problem of providing a telecommunication apparatus with air filtering, wherein the air filter may be installed and/or removed without disconnecting the cables connected to the telecommunication devices arranged on the boards of the telecommunication apparatus.

According to an aspect thereof, the present invention provides a telecommunication apparatus with air filtering, the telecommunication apparatus including a plurality of boards, a fan unit for generating an air flow for cooling the plurality of boards and an air filter for filtering the air flow, characterized in that it further comprises a guiding structure, the air filter slidably cooperating with the guiding structure so that the air filter is slidable between a non operative position, wherein the air filter is applicable to and removable from the telecommunication apparatus, and an operative position, wherein the air filter actually filters the air flow.

Preferably, the telecommunication apparatus has a casing for housing the plurality of boards, the fan unit and the air filter, the casing having a substantially parallelepiped shape with a sidewall having a side opening and a top having a recess, the sidewall and the top forming a corner.

Profitably, in the non operative position, the air filter engages the recess while, in the operative position, a first portion of the air filter engages at least part of the side opening.

Preferably, in the operative position, a second portion of the air filter engages at least part of the recess.

Preferably, the guiding structure comprises top grooves extending along opposite sides of the recess and side grooves extending along opposite edges of the side opening, the top grooves being jointed to the side grooves at the corner, so that the guiding structure is bent substantially by 90° at the corner.

Preferably, the corner formed by the sidewall and the top is beveled.

Preferably, the telecommunication apparatus further comprises a sliding frame suitable to slidably engage the guiding structure and configured to support the air filter, thus allowing the air filter to slidably cooperate with the guiding structure.

Profitably, the sliding frame comprises a first plurality of jointed segments forming a first articulated structure, a second plurality of jointed segments forming a second articulated structure, and a plurality of sticks connecting the first articulated structure and the second articulated structure.

### Brief description of the drawings

The present invention will become clearer by reading the following detailed description, given by way of example and not of limitation, to be read with reference to the accompanying drawings wherein:
- Figure 1 schematically shows a telecommunication apparatus with air filtering, according to a first embodiment of the present invention;
- Figure 2 shows the telecommunication apparatus of Figure 1, wherein the air filter is in its installation/removal position;
- Figure 3 shows the telecommunication apparatus of Figure 1, wherein the air filter is in a intermediate position;
- Figure 4 shows the telecommunication apparatus of Figure 1, wherein the air filter is in its operative position;
- Figure 5 schematically shows a telecommunication apparatus with air filtering, according to a second embodiment of the present invention;
- Figure 6 shows the telecommunication apparatus of Figure 5, wherein the sliding frame with the air filter is in its installation/removal position;
- Figure 7 shows the telecommunication apparatus of Figure 5, wherein the sliding frame with the air filter is in a intermediate position;
- Figure 8 shows the telecommunication apparatus of Figure 5, wherein the sliding frame with the air filter is in its operative position; and
- Figure 9 shows in detail a sliding frame according to an embodiment of the present invention.

### Detailed description of preferred embodiments of the invention

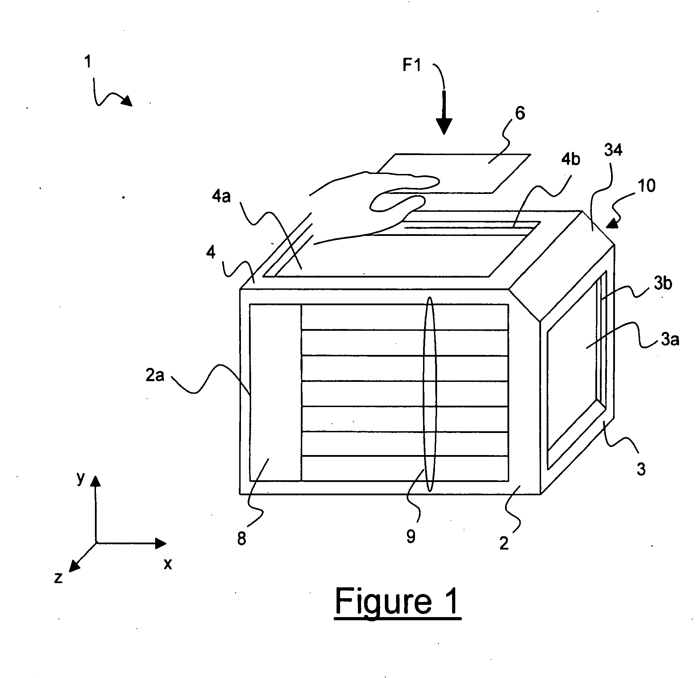

Herein after, by referring to Figures 1 to 4, a telecommunication apparatus 1 with air filtering according to a first embodiment of the present invention will be described in detail. Figures 1 to 4 are not in scale.

The telecommunication apparatus 1 preferably comprises a casing 10, a fan unit 8 (in turn comprising one or more fans which are not shown) and a plurality of boards 9.

The casing 10 preferably has a substantially parallelepiped shape. More particularly, the casing 10 has a front wall 2 with a front opening 2a, a first sidewall 3 with a first side opening 3a and a top 4. Further, the casing 10 has a base and a second sidewall with a second side opening, which are not visible in Figures 1 to 4.

The casing 10 is preferably configured to house the fan unit 8 and the boards 9.

Preferably, the boards 9 are arranged parallel to a plane (which in Figures 1 to 4 is substantially horizontal) defined by a first direction x and a second direction z perpendicular to the first direction x.

Further, preferably, the fan unit 8 is arranged parallel to a further plane (which in Figures 1 to 4 is substantially vertical) defined by the second direction z and a third direction y perpendicular to x and z. The fan unit 8 is preferably arranged within the casing 10 in front of the second side opening of the second sidewall (this is not visible in Figures 1 to 4). Therefore, advantageously, when the fan unit 8 is switched on, it generates an air flow parallel to the first direction x. Further, preferably, the fans of the fan unit 8 are sucking fans.

According to preferred embodiments of the present invention, the top 4 has a recess 4a. Preferably, the recess 4a has a substantially rectangular bottom surface and four side surfaces. Preferably, the side surfaces parallel to the plane defined by the directions x and y have respective top grooves 4b extending in the direction x. The top grooves 4b are preferably configured to engage with opposite edges of an air filter, as it will be described in further detail herein after. Further, preferably, the side surface (not visible in Figures 1 to 4) parallel to the plane defined by the directions y and z and facing the first sidewall 3 has a slit configured to allow the passage of an air filter.

Further, according to preferred embodiments of the present invention, the first side opening 3a of the first sidewall 3 is substantially rectangular, thus having four sides. The sides parallel to the direction y have respective side grooves 3b extending in the direction y. The side grooves 3b are preferably configured to engage with opposite edges of an air filter, as it will be described in further detail herein after. Further, preferably, the side (not visible in Figures 1 to 4) parallel to the direction z and facing the top 4 has a slit configured to allow the passage of an air filter.

Preferably, the top grooves 4b and the side grooves 3b join each other within the casing 10 at the corner 34 formed by the top 4 and the first sidewall 3, thus forming a continuous guiding structure which is bent by 90° at the corner 34. Further, according to preferred embodiments of the present invention, the corner 34 is beveled, as shown in Figures 1 to 4. This advantageously prevents the guiding structure from bending with a sharp corner, so that an air filter guided by the guiding structure can pass through the bending zone without blocking or being damaged. Although the corner 34 shown in Figures 1 to 4 has a trapezoid shape, according to other embodiments not shown in the drawings it could have other shapes, such as for instance a rounded shape.

Herein after, by referring to Figures 1 to 4, the various steps for installing an air filter 6 in the telecommunication apparatus 1 will be described in detail.

By referring to Figure 1, the air filter 6 is preferably arranged parallel to the plane defined by the directions x and z, and then it is brought in the proximity of the top 4 of the casing 10.

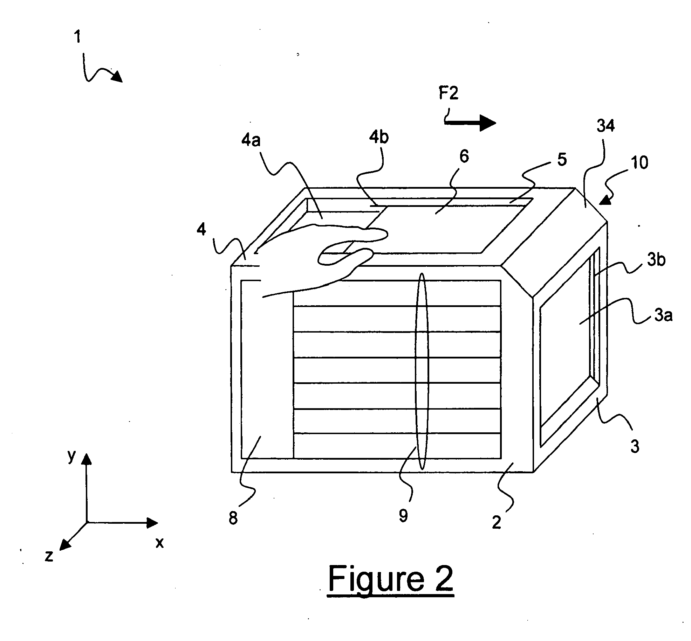

The air filter 6 is then pushed in the direction indicated by the arrow F1 of Figure 1, until it engages the recess 4a of the top 4, as shown in Figure 2. The air filter 6 is now in its installation/removal position. Preferably, the air filter 6 has a length (which corresponds to its size along the direction x) and a thickness (which corresponds to its size along the direction y) lower than the length and depth of the recess 4a, respectively. This advantageously allows the air filter 6 not to protrude out of the recess 4a when engaging it. Further, preferably, the air filter 6 has a width (which corresponds to its size along the direction z) which is slightly higher than the width of the recess 4a. This advantageously allows the air filter 6 to engage with the top grooves 4b through its edges parallel to the direction x. Since the thickness of the air filter 6 is preferably remarkably lower than its width and length, the air filter 6 is represented in Figures 1 to 4 as a substantially bidimensional object.

Preferably, the filter length is comprised between 15 and 25 cm. More preferably, the filter length is equal to about 20 cm. Preferably, the filter width is comprised between 15 and 25 cm. More preferably, the filter width is equal to about 20 cm. Preferably, the filter thickness is comprised between 4 and 10 mm. More preferably, the filter thickness is equal to about 7 mm.

The edges of the air filter 6 which are parallel to the direction x are then inserted in the top grooves 4b, as shown in Figure 2.

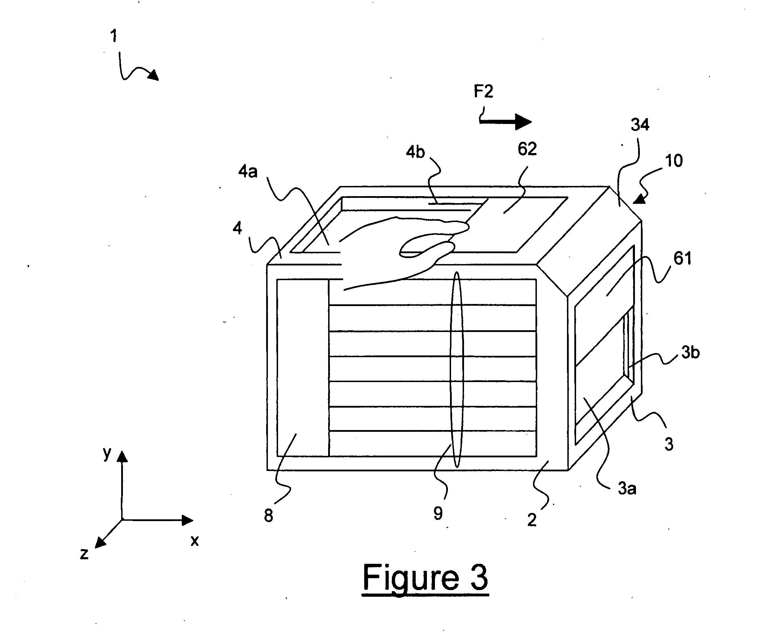

Then, the air filter 6 is preferably pushed in the direction indicated by the arrow F2 of Figure 2. In this way, the air filter 6, guided by the guiding structure, moves from its installation/removal position to an intermediate position which is shown in Figure 3. In this intermediate position, a first portion 61 of the air filter 6 partially covers the first side opening 3a, while a second portion 62 thereof still engages the recess 4a. The first portion 61 is substantially perpendicular to the second portion 62 since, at the corner 34, the air filter 6 follows the 90° bend of the guiding structure.

Therefore, preferably, the air filter 6 has a flexible behavior around a bending axis parallel to the direction z. This advantageously allows the air filter 6 to follow the 90° bend of the guiding structure without blocking or breaking. Further, preferably, the air filter 6 has a rigid behavior when subjected to a force directed along the direction x. This advantageously allows to push the air filter 6 along the direction indicated by the arrow F2 without the risk that the friction force exerted by the grooves 4b and 3b on the air filter 6 deforms it.

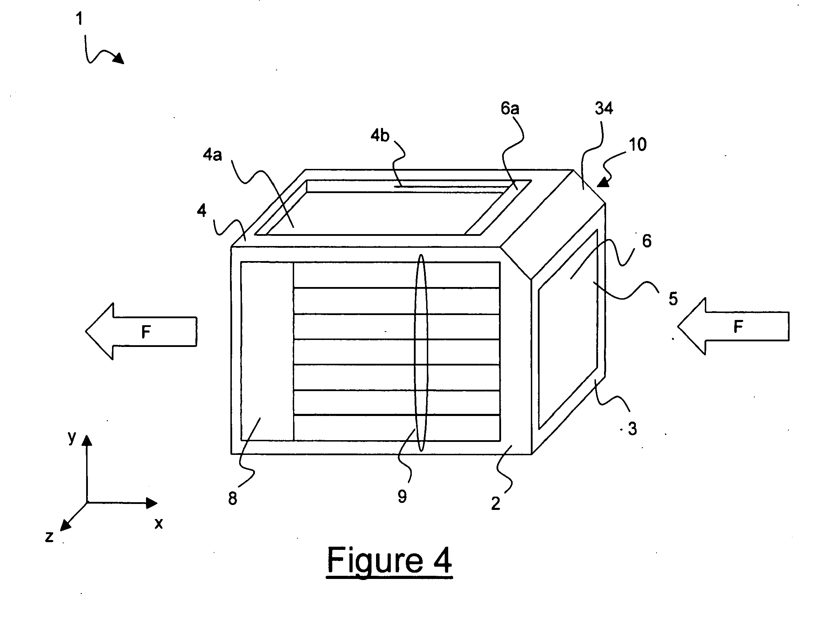

By continuing to push the air filter 6 in the direction indicated by the arrow F2, the air filter 6 further slides within the top grooves 4b and the side grooves 3b, until it reaches its operative position, which is shown in Figure 4, wherein it substantially completely covers the first side opening 3a.

Therefore, when the air filter 6 is in its operative condition, the fan unit 8 may be switched on, thus creating an air flow F (which is shown in Figure 4) which enters the casing 10 through the air filter 6, flows across the boards 9 and finally exits the casing 10 through the second side opening (not shown in Figure 4).

Preferably, when the air filter 6 is in its operative position, a portion 6a thereof still engages the recess 4a, as shown in Figure 4. This advantageously allows to remove the air filter 6. Indeed, when an operator wishes to remove the air filter 6 (e.g. for replacing it with a new clean air filter), the operator may pull the portion 6a in a direction opposite to the direction indicated by the arrow F2. The air filter 6 then slides back to its intermediate position, and finally to its installation/removal position in the recess 4a. The operator can then remove the air filter 6 from the recess 4a.

Therefore, advantageously, the air filter 6 may be installed and/or removed without disconnecting possible cables which exit the casing 10 through the front opening 2a and are fixed to the rack supporting the casing 10 preventing the first sidewall 3 from being accessed.

Indeed, advantageously, the various steps of installation and removal of the air filter 6 do not require the operator to directly access the first sidewall 3 with his hand(s). Indeed, thanks to the guiding structure which is shaped for guiding the air filter 6 between its installation/removal position and its operative position, the air filter 6 may be brought into its operative condition by simply inserting it in the recess 4a, engaging its edges with the top grooves 4b and pushing it along the direction indicated by F2. An operator may advantageously perform all these operations by keeping its hand(s) on the top 4 of the casing 10.

Further, advantageously, when the telecommunication apparatus 1 is fixed to a rack with other telecommunication apparatuses, the distance between the telecommunication apparatus 1 and a telecommunication apparatus fixed above it may be very small, e.g. 10 cm. Indeed, the operations for installing or removing the air filter 6 can advantageously be performed in a very small space. Indeed, the operator may perform such operations by always keeping both the air filter 6 and its hands substantially parallel to the top 4.

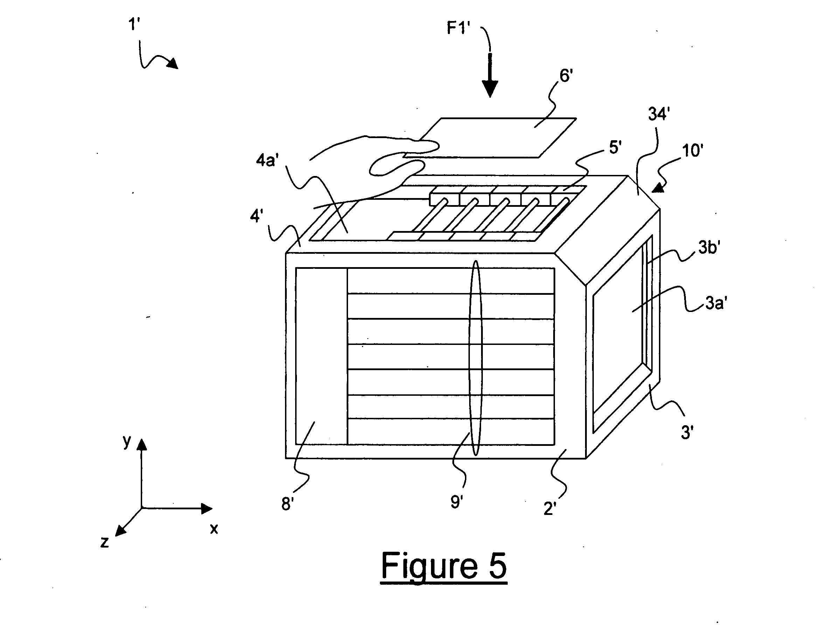

Herein after, by referring to Figure 5 to 8, a telecommunication apparatus 1' with air filtering according to a second embodiment of the present invention will be described in detail. Figures 5 to 8 are not in scale.

Similarly to the telecommunication apparatus 1, the telecommunication apparatus 1' preferably comprises a casing 10', a fan unit 8' (in turn comprising one or more fans) and a plurality of boards 9'.

The casing 10' preferably has a substantially parallelepiped shape. More particularly, the casing 10' has a front wall 2' with a front opening 2a', a first sidewall 3' with a first side opening 3a' and a top 4'. Further, the casing 10' has a base and a second sidewall with a second side opening, which are not visible in Figures 5 to 8.

The casing 10' is preferably configured to house the fan unit 8' and the boards 9'.

Preferably, the boards 9' are arranged parallel to a plane (which in Figures 5 to 8 is substantially horizontal) defined by the directions x and z.

Further, preferably, the fan unit 8' is arranged parallel to a further plane (which in Figures 5 to 9 is substantially vertical) defined by the directions z and y. The fan unit 8' is preferably arranged within the casing 10' in front of the second side opening of the second sidewall (this is not visible in Figures 5 to 8). Therefore, advantageously, when the fan unit 8' is switched on, it generates an air flow parallel to the first direction x. Further, preferably, the fans of the fan unit 8' are sucking fans.

According to preferred embodiments of the present invention, the top 4' has a recess 4a'. Preferably, the recess 4a' has a substantially rectangular bottom surface and four side surfaces. Preferably, the side surfaces parallel to the plane defined by the directions x and y have respective top grooves 4b' extending in the direction x. The top grooves 4b' are preferably configured to engage with a sliding frame 5', as it will be described in further detail herein after. Further, preferably, the side surface (not visible in Figures 5 to 8) parallel to the plane defined by the directions y and z and facing the first sidewall 3 has a slit configured to allow the passage of the sliding frame 5'.

Further, according to preferred embodiments of the present invention, the first side opening 3a' of the first sidewall 3' is substantially rectangular, thus having four sides. The sides parallel to the direction y have respective side grooves 3b' extending in the direction y. The side grooves 3b' are preferably configured to engage with the sliding frame 5', as it will be described in further detail herein after. Further, preferably, the side (not visible in Figures 5 to 8) parallel to the direction z and facing the top 4' has a slit configured to allow the passage of the sliding frame 5'.

Preferably, the top grooves 4b' and the side grooves 3b' join each other within the casing 10' at the corner 34' formed by the top 4' and the first sidewall 3', thus forming a continuous guiding structure which is bent by 90° at the corner 34'. Further, according to preferred embodiments of the present invention, the corner 34' is beveled, as shown in Figures 5 to 8. This advantageously prevents the guiding structure from bending with a sharp corner, so that the sliding frame 5' guided by the guiding structure can pass through the bending zone without blocking or being damaged. Although the corner 34' shown in Figures 5 to 8 has a trapezoid shape, according to other embodiments not shown in the drawings it could have other shapes, such as for instance a rounded shape.

Preferably, as already mentioned, the telecommunication apparatus 1' further comprises a sliding frame 5', which slidably engages the guiding structure comprising the top grooves 4b' and the side grooves 3b'.

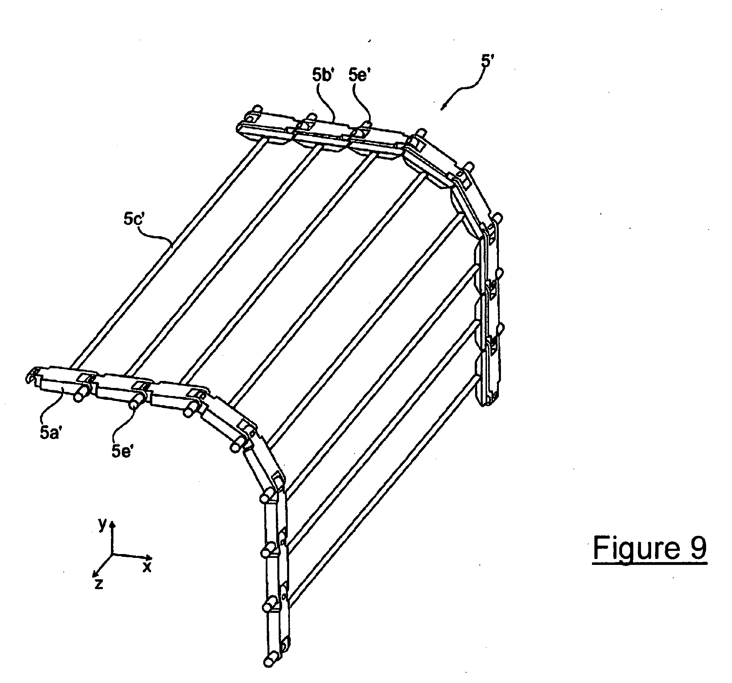

As shown in Figure 9, the sliding frame 5' preferably comprises a first plurality of jointed segments 5a' and a second plurality of jointed segments 5b'. Each segment 5a' and 5b' is rotatable on a plane defined by the directions x and y with respect to the adjacent segments. The sliding frame 5' further comprises a plurality of sticks 5c', wherein each stick 5c' connects a segment 5a' of the first plurality to a corresponding segment 5b' of the second plurality. Accordingly, advantageously, the sliding frame 5' has a flexible behavior around a bending axis parallel to the direction z. This advantageously allows the sliding frame 5' to follow the 90° bend of the guiding structure without blocking or breaking. Further, advantageously, the sliding frame 5' has a rigid behavior when subjected to a force directed along the direction x. This advantageously allows to push or pull the sliding frame 5' along the direction x without the risk that the friction force exerted by the grooves 4b' and 3b' deforms it.

Preferably, the sliding frame 5' is made of a plastic material, in particular a UL 94 V0 fire resistant plastic. Alternatively, the sliding frame 5' is metallic.

Further, preferably, each segment 5a', 5b' has a respective pin 5e' configured to engage the top grooves 4b' and the side grooves 3b'.

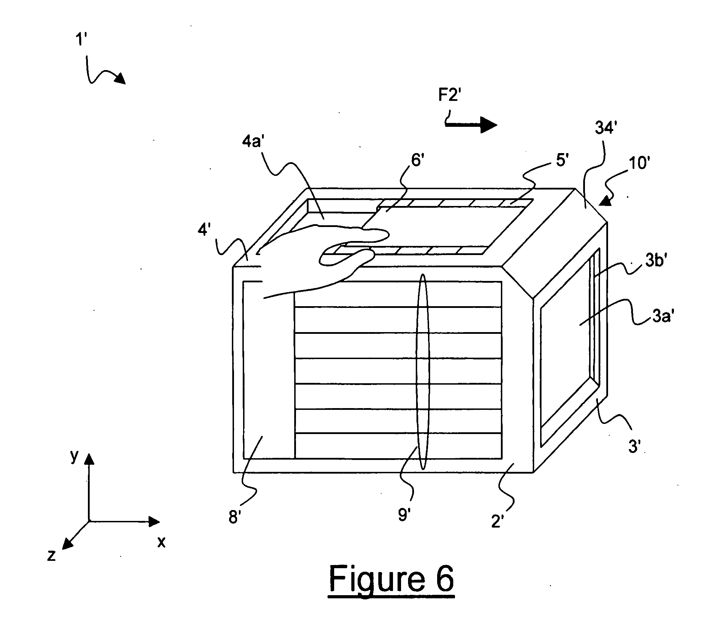

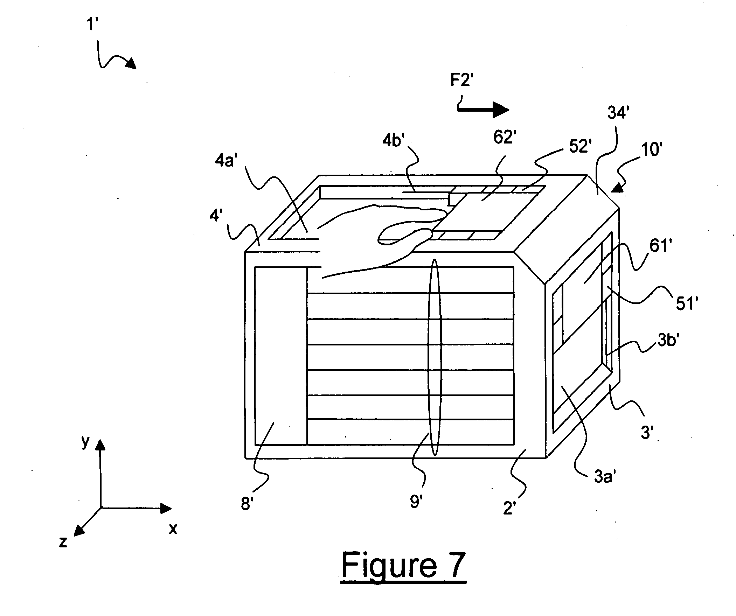

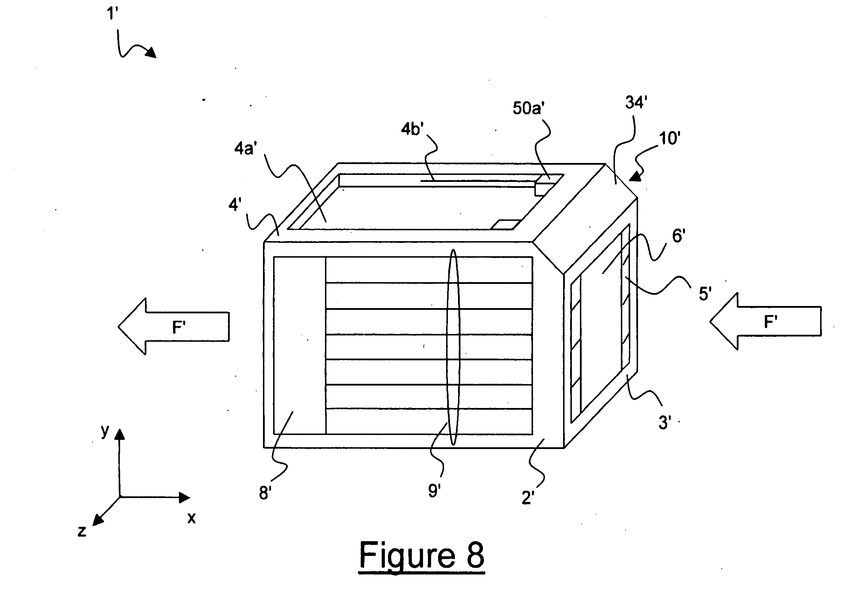

According to preferred embodiments of the present invention, the sliding frame 5', guided by the guiding structure, is slidable between an installation/removal position (see Figures 5 and 6), wherein it engages the recess 4a, and an operative position (see Figure 8), wherein it covers the first side opening 3a'. In an intermediate position, which is shown in Figure 7, a first portion 51' of the slidable frame 5' partially covers the first side opening 3a', while a second portion 52' of the slidable frame 5' still engages the recess 4a'.

Herein after, by referring to Figures 5 to 8, the various steps for installing an air filter 6' in the telecommunication apparatus 1' will be described in detail.

By referring to Figure 5, the air filter 6' is preferably arranged parallel to the plane defined by the directions x and z, and then it is brought in the proximity of the top 4' of the casing 10'. The sliding frame 5' is preferably in its installation/removal position.

The air filter 6' is then pushed in the direction indicated by the arrow F1' of Figure 5, until it is coupled to the sliding frame 5'. Optionally, the air filter 6' may be fixed to the sliding frame 5'. To this purpose, the sliding frame 5' may be provided with a plurality of pins protruding on its upper side and suitable to engage corresponding holes of the air filter 6'.

Then, the air filter 6' is preferably pushed in the direction indicated by the arrow F2' of Figure 6. In this way, the sliding filter 5' with the air filter 6', guided by the guiding structure comprising the top grooves 4b' and the side grooves 3b', moves from its installation/removal position to an intermediate position which is shown in Figure 7.

Preferably, the air filter 6' is made of a flexible material, such as for instance a synthetic sponge material. This advantageously allows the air filter 6' to follow the deformations that the sliding frame 5' undergoes while sliding in the guiding structure.

By continuing to push the sliding frame 5' in the direction indicated by the arrow F2', the sliding frame 5' with the air filter 6' further slides within the top grooves 4b' and the side grooves 3b', until it reaches its operative position, which is shown in Figure 8.

Therefore, when the sliding frame 5' with the air filter 6' is in its operative condition, the fan unit 8' may be switched on, thus creating an air flow F' (which is shown in Figure 8) which enters the casing 10' through the air filter 6', flows across the boards 9' and finally exits the casing 10' through the second side opening (not shown in Figure 8).

Preferably, when the sliding frame 5' is in its operative position, a portion 50a' thereof still engages the recess 4a', as shown in Figure 8. This advantageously allows to remove the air filter 6'. Indeed, when an operator wishes to remove the air filter 6' (e.g. for replacing it with a new clean air filter), the operator may pull the portion 50a' of the sliding frame 5' in a direction opposite to the direction indicated by the arrow F2'. The sliding frame 5' then slides back to its intermediate position, and finally to its installation/removal position in the recess 4a'. The operator can then remove the air filter 6' from the sliding frame 5'.

Therefore, advantageously, also according to this second embodiment, installation and removal of the air filter 6' can be performed without disconnecting the cables, since the first sidewall 3 is indirectly accessed through the top 4.

Further, thanks to the sliding frame 5', the air filter 6' may advantageously be a known air filter, such as a conventional 7 mm thick synthetic sponge foil. Indeed, the only mechanical feature that the air filter 6' should have is flexibility for following deformations of the sliding frame. Mechanical resilience of the air filter is no more required, since such a feature is provided by the sliding frame.

## Claims

1. Telecommunication apparatus (TA) with air filtering, said telecommunication apparatus (TA) including a plurality of boards (9), a fan unit (8) for generating an air flow (F) for cooling said plurality of boards (9) and an air filter (6) for filtering said air flow (F), **characterized in that** it further comprises a guiding structure (4b, 3b), said air filter (6) slidably cooperating with said guiding structure (4b, 3b) so that said air filter (6) is slidable between a non operative position, wherein said air filter (6) is applicable to and removable from said telecommunication apparatus (1), and an operative position, wherein said air filter (9) actually filters said air flow (F).

2. The telecommunication apparatus (TA) according to claim 1, wherein said telecommunication apparatus (TA) has a casing (10) for housing said plurality of boards (9), said fan unit (8) and said air filter (6), said casing (10) having a substantially parallelepiped shape with a sidewall (3) having a side opening (3a) and a top (4) having a recess (4a), said sidewall (3) and said top (4) forming a corner (34).

3. The telecommunication apparatus according to claim 2, wherein, in said non operative position, said air filter (6) engages said recess (4a).

4. The telecommunication apparatus according to claim 1 or 2, wherein, in said operative position, a first portion of said air filter (6) engages at least part of said side opening (3a).

5. The telecommunication apparatus according to any of the preceding claims, wherein, in said operative position, a second portion of said air filter (6) engages at least part of said recess (4a).

6. The telecommunication apparatus (TA) according to any of claims 2 to 5, wherein said guiding structure (4b, 3b) comprises top grooves (4b) extending along opposite sides of said recess (4a) and side grooves (3b) extending along opposite edges of said side opening (3a), said top grooves (4b) being jointed to said side grooves (3b) at said corner (34), so that said guiding structure (4b, 3b) is bent substantially by 90° at said corner (34).

7. The telecommunication apparatus according to any of claims 2 to 6, wherein said corner (34) formed by said sidewall (3) and said top (4) is beveled.

8. The telecommunication apparatus (TA) according to any of the preceding claims, further comprising a sliding frame (5') suitable to slidably engage said guiding structure (4b', 4a') and configured to support said air filter (6'), thus allowing said air filter (6') to slidably cooperate with said guiding structure (4b', 4a').

9. The telecommunication apparatus (TA) according to claim 2, wherein the sliding frame (5) comprises a first plurality of jointed segments (5a') forming a first articulated structure, a second plurality of jointed segments (5b') forming a second articulated structure, and a plurality of sticks connecting said first articulated structure and said second articulated structure.

## Patentansprüche

1. Telekommunikationsvorrichtung (TA) mit Luftfilter, wobei die besagte Telekommunikationsvorrichtung (TA) eine Vielzahl von Leiterplatten (9), eine Lüftereinheit (8) zum Erzeugen eines Luftstroms (F) zum Kühlen der besagten Vielzahl von Leiterplatten (9) und einen Luftfilter (6) zum Filtern des besagten Luftstroms (F) umfasst, **dadurch gekennzeichnet, dass** sie weiterhin eine Führungsstruktur (4b, 3b) umfasst, wobei der besagte Luftfilter (6) gleitbar mit der besagten Führungsstruktur (4b, 3b) zusammenwirkt, so dass der besagte Luftfilter (6) zwischen einer Nicht-Betriebsposition, in welcher der besagte Luftfilter (6) auf der besagten Telekommunikationsvorrichtung (1) anbringbar und davon abnehmbar ist, und einer Betriebsposition, in welcher der besagte Luftfilter (9) den besagten Luftstrom (F) tatsächlich filtert, verschiebbar ist.

2. Die Telekommunikationsvorrichtung (TA) nach Anspruch 1, wobei die besagte Telekommunikationsvorrichtung (TA) mit einem Gehäuse (10) zur Aufnahme der besagten Vielzahl von Leiterplatten (9), der besagten Lüftereinheit (8) und des besagten Luftfilters (6) ausgestattet ist, wobei das Gehäuse (10) eine im Wesentlichen parallelepipede Form mit einer mit einer seitlichen Öffnung (3a) versehenen Seitenwand (3) und einer mit einer Vertiefung (4a) versehenen Abdeckung (4) aufweist, wobei die besagte Seitenwand (3) und die besagte Abdeckung (4) eine Abwinklung (34) bilden.

3. Die Telekommunikationsvorrichtung nach Anspruch 2, wobei der Luftfilter (6) in der besagten Nicht-Betriebsposition in die besagte Vertiefung (4a) einrastet.

4. Die Telekommunikationsvorrichtung nach Anspruch 1 oder 2, wobei ein erster Abschnitt des besagten Luftfilters (6) in der besagten Betriebsposition mindestens in einen Teil der besagten seitlichen Öffnung (3a) einrastet.

5. Die Telekommunikationsvorrichtung nach einem beliebigen der vorstehenden Ansprüche, wobei ein zweiter Abschnitt des besagten Luftfilters (6) in der besagten Betriebsposition mindestens in einen Teil der besagten Vertiefung (4a) einrastet.

6. Die Telekommunikationsvorrichtung (TA) nach einem beliebigen der Ansprüche 2 bis 5, wobei die besagte Führungsstruktur (4b, 3b) obere Nuten (4b), welche entlang den sich gegenüberliegenden Selten der besagten Vertiefung (4a) verlaufen, sowie seitliche Nuten (3b), welche entlang den sich gegenüberliegenden Kanten der besagten seitlichen Öffnung (3a) verlaufen, umfasst, wobei sich die besagten oberen Nuten (4b) mit den besagten seitlichen Nuten (3b) an der besagten Abwinklung (34) zusammenfügen, so dass die besagte Führungsstruktur (4b, 3b) an der besagten Abwinklung (34) im Wesentlichen um 90° gebogen ist.

7. Die Telekommunikationsvorrichtung nach einem beliebigen der Ansprüche 2 bis 6, wobei die besagte Abwinklung (34), welche von der besagten Seitenwand (3) und der besagten Abdeckung (4) gebildet wird, abgeschrägt ist.

8. Die Telekommunikationsvorrichtung (TA) nach einem beliebigen der vorstehenden Ansprüche, weiterhin umfassend einen Gleitrahmen (5'), welcher gleitend in die besagte Führungsstruktur (4b', 4a') einschiebbar und konfiguriert ist, um den besagten Luftfilter (6') zu stützen, wodurch der besagte Luftfilter (6') befähigt wird, gleitend mit der besagten Führungsstruktur (4b, 4a') zusammenzuwirken.

9. Die Telekommunikationsvorrichtung (TA) nach Anspruch 2, wobei der Gleitrahmen (5) eine erste Vielzahl von zusammengefügten Segmenten (5a'), welche eine erste Gelenkstruktur bilden, eine zweite Vielzahl von zusammengefügten Segmenten (5b'), welche eine zweite Gelenkstruktur bilden, und eine Vielzahl von Stäben, welche die besagte erste Gelenkstruktur und die besagte zweite Gelenkstruktur verbinden, umfasst.

## Revendications

1. Appareil de télécommunication (TA) avec filtrage de l'air, ledit appareil de télécommunication (TA) contenant une pluralité de cartes (9), un ventilateur (8) pour générer un courant d'air (F) afin de refroidir ladite pluralité de cartes (9) et un filtre à air (6) pour filtrer ledit courant d'air (F), **caractérisé en ce qu'**il comprend en outre une structure de guidage (4b, 3b), ledit filtre à air (6) se trouvant dans une relation de coulissement avec ladite structure de guidage (4b, 3b) de sorte que ledit filtre à air (6) peut coulisser entre une position non opérationnelle, dans laquelle ledit filtre à air (6) peut être posé dans ledit appareil de télécommunication (1) et en être retiré, et une position opérationnelle dans laquelle ledit filtre à air (6) filtre effectivement ledit courant d'air (F).

2. Appareil de télécommunication (TA) selon la revendication 1, ledit appareil de télécommunication (TA) comprenant un boîtier (10) pour accueillir ladite pluralité de cartes (9), ledit ventilateur (8) et ledit filtre à air (6), ledit boîtier (10) ayant une forme pour l'essentiel parallélépipédique avec une paroi latérale (3) munie d'une ouverture latérale (3a) et un dessus (4) muni d'un enfoncement (4a), ladite paroi latérale (3) et ledit dessus (4) formant un coin (34).

3. Appareil de télécommunication selon la revendication 2, selon lequel, dans ladite position non opérationnelle, ledit filtre à air (6) s'engage dans ledit enfoncement (4a).

4. Appareil de télécommunication selon la revendication 1 ou 2, selon lequel, dans ladite position opérationnelle, une première portion dudit filtre à air (6) s'engage dans au moins une partie de ladite ouverture latérale (3a).

5. Appareil de télécommunication selon l'une quelconque des revendications précédentes, selon lequel, dans ladite position opérationnelle, une deuxième portion dudit filtre à air (6) s'engage dans au moins une partie dudit enfoncement (4a).

6. Appareil de télécommunication (TA) selon l'une quelconque des revendications 2 à 5, ladite structure de guidage (4b, 3b) comprenant des rainures supérieures (4b) qui s'étendent le long des côtés opposés dudit enfoncement (4a) et des rainures latérales (3b) qui s'étendent le long des côtés opposés de ladite ouverture latérale (3a), lesdites rainures supérieures (4b) étant jointes auxdites rainures latérales (3b) au niveau dudit coin (34) de sorte que ladite structure de guidage (4b, 3b) est pliée sensiblement de 90° au niveau dudit coin (34).

7. Appareil de télécommunication (TA) selon l'une quelconque des revendications 2 à 6, ledit coin (34) formé par ladite paroi latérale (3) et ledit dessus (4) étant chanfreiné.

8. Appareil de télécommunication (TA) selon l'une quelconque des revendications précédentes, comprenant en outre un cadre coulissant (5') conçu pour s'engager de manière coulissante dans ladite structure de guidage (4b', .4a') et configuré pour supporter ledit filtre à air (6'), permettant ainsi audit filtre à air (6') à interagir de manière coulissante avec ladite structure de guidage (4b', 4a').

9. Appareil de télécommunication (TA) selon la revendication 2, le cadre coulissant (5) comprenant une première pluralité de segments joints (5a') formant une première structure articulée, une deuxième pluralité de segments joints (5b') formant une deuxième structure articulée et une pluralité de baguettes qui relient ladite première structure articulée avec ladite deuxième structure articulée.
